Europäisches Patentamt

European Patent Office

Office européen des brevets

(19)

(11) Numéro de publication : **0 667 677 A1**

## (12) DEMANDE DE BREVET EUROPEEN

(21) Numéro de dépôt : 95400246.5

(22) Date de dépôt : 06.02.95

(51) Int. Cl.⁶ : **H03H 11/04,** H03H 11/40, H03H 11/48

(30) Priorité : **09.02.94 FR 9401454**

(43) Date de publication de la demande :
**16.08.95 Bulletin 95/33**

(84) Etats contractants désignés :
**AT BE CH DE DK ES FR GB IT LI NL SE**

(71) Demandeur : **ALCATEL MOBILE
COMMUNICATION FRANCE
10, rue de la Baume
F-75008 Paris (FR)**

(72) Inventeur : **Genest, Pierre
8, Rue A. Renoir
F-95430 Butry sur Oise (FR)**

(74) Mandataire : **El Manouni, Josiane et al
SOSPI
14-16, rue de la Baume
F-75008 Paris (FR)**

(54) **Dispositif de multiplication d'une capacité par un coefficient variable, notamment en vue de l'ajustement d'une fréquence de coupure d'un filtre, et filtre comportant un tel dispositif.**

(57)     Dispositif de multiplication d'une capacité par un coefficient variable, notamment en vue du réglage de la fréquence de coupure d'un filtre incluant une telle capacité, ce dispositif comportant des moyens d'amplification de courant permettant d'amplifier un courant traversant ladite capacité, et étant essentiellement caractérisé en ce que, ladite capacité étant du type flottante entre un premier (A) et un second (B) point déterminé, lesdits moyens d'amplification de courant comportent un amplificateur de courant différentiel (42, 53).

Fig. 4A

EP 0 667 677 A1

Le domaine de l'invention est celui des filtres comprenant au moins une capacité et dont une fréquence de coupure est fonction notamment de cette capacité.

Plus précisément, l'invention concerne un dispositif d'ajustement d'une fréquence de coupure d'un filtre du type précité (à savoir comprenant au moins une capacité en fonction de laquelle varie la fréquence de coupure à ajuster).

On connaît dans l'état de la technique de nombreux filtres comprenant au moins une capacité, et notamment les filtres LC (c'est-à-dire les filtres à inductance(s) et capacité(s)).

Ces filtres connus comprenant au moins une capacité présentent plusieurs inconvénients.

Un premier inconvénient de ces filtres connus est lié au fait que plus les fréquences de coupure désirées sont basses, plus les capacités doivent être grandes. Un filtrage en basses fréquences nécessite par conséquent l'utilisation de capacités importantes qui présentent de grandes dimensions et dont l'intégration, par exemple dans un ASIC, est très difficile.

Un second inconvénient de ces filtres connus est qu'il est très difficile d'ajuster leur(s) fréquence(s) de coupure car les composants utilisés, et notamment la ou les capacités sont généralement légèrement différents des composants types prévus lors de leur conception.

Un troisième inconvénient de ces filtres connus est qu'ils présentent une consommation élevée du fait de leur structure rebouclée à base d'amplificateur(s) opérationnel(s). La consommation élevée provient du fait que l'amplificateur opérationnel doit présenter un produit gain-bande très supérieur à la gamme de fréquences que l'on souhaite réellement traiter, afin d'éviter qu'un courant de fuite ne court-circuite l'amplificateur par des éléments passifs de la boucle de contre-réaction.

Il est également connu, dans l'état de la technique, d'ajuster la fréquence de coupure d'un filtre en multipliant une capacité de ce filtre par un coefficient variable.

Cette capacité peut alors être de faible valeur et donc de taille réduite puisqu'elle est destinée à être multipliée par un coefficient variable, la valeur de ce coefficient variable étant fonction de la fréquence de coupure désirée pour le filtre à régler. En d'autres termes, même pour un filtrage très basse fréquence nécessitant une valeur élevée de capacité, ceci permet d'utiliser une capacité de faible valeur, les moyens de multiplication du dispositif d'ajustement permettant d'obtenir la valeur élevée à partir de la faible valeur par une multiplication par un coefficient variable.

On connaît également, dans l'état de la technique, des moyens de multiplication de capacité comprenant des moyens d'amplification de courant permettant d'amplifier un courant traversant ladite capacité.

Ainsi, le filtre à régler ne comporte pas d'amplificateurs opérationnels et sa consommation est réduite par rapport aux filtres connus possédant une structure à base d'amplificateurs opérationnels.

La présente invention a pour objet un dispositif de multiplication d'une capacité par un coefficient variable, notamment en vue du réglage de la fréquence de coupure d'un filtre incluant une telle capacité, ce dispositif comportant des moyens d'amplification de courant permettant d'amplifier un courant traversant ladite capacité, et étant essentiellement caractérisé en ce que, ladite capacité étant du type flottante entre un premier et un second point déterminé, lesdits moyens d'amplification de courant comportent un amplificateur de courant différentiel.

Selon un premier mode de réalisation ledit amplificateur de courant différentiel comporte une première entrée $(e^+)$ recevant un courant représentatif du courant traversant ladite capacité, une seconde entrée (e-) non connectée, une première sortie (s+) inverseuse présentant un premier gain d'amplification de courant différentiel G et reliée audit premier point prédéterminé (A), et une seconde sortie (s-) suiveuse présentant un second gain d'amplification de courant différentiel G+1 et reliée audit second point déterminé (B).

En variante, selon ce premier mode de réalisation lesdits moyens d'amplification de courant comportent en outre un convoyeur de courant,

ladite capacité (C) possédant une première borne reliée audit premier point prédéterminé (A), et une seconde borne reliée à une entrée (X) de courant à amplifier dudit convoyeur de courant,

ledit convoyeur de courant comportant ladite entrée (X) de courant à amplifier reliée à la seconde borne de ladite capacité, une sortie (Z) inverseuse de courant reliée à une première entrée $(e^+)$ dudit amplificateur de courant différentiel, et une entrée (Y) de commande reliée audit second point prédéterminé (B),

et la première entrée $(e^+)$ dudit amplificateur de courant différentiel étant reliée à la sortie (Z) inverseuse de courant dudit convoyeur de courant.

La dissymétrie entre les courants en sortie de l'amplificateur de courant différentiel vient de la nécessité de voir la même capacité sur les points prédéterminés entre lesquels la capacité du filtre à régler est flottante, et donc les mêmes courants de part et d'autre de la capacité fictive que constitue l'ensemble formé de la capacité du filtre à régler, du convoyeur de courant et de l'amplificateur de courant différentiel. Si la capacité du filtre à régler est C, cette capacité fictive est (G + 1). C. Les avantages de cette structure sont notamment ceux de l'amplificateur de courant différentiel, à savoir un faible bruit, un faible offset, une large bande passante, une bonne linéarité, et une bonne précision sur le gain. Il est important de noter que cette bonne linéarité et cette bonne précision sur le gain permettent d'ajuster avec précision la fréquence de coupure du filtre à régler.

Selon un autre mode de réalisation, ladite capacité (C/2) du filtre à régler étant du type flottante entre un premier (A) et un second (B) point prédéterminé, lesdits moyens d'amplification de courant comportent en outre une capacité supplémentaire (C'/2) sensiblement identique à ladite capacité du filtre à régler, la capacité (C/2) du filtre à régler possédant une première borne reliée audit premier point prédéterminé (A), et une seconde borne,
la capacité supplémentaire (C'/2) possédant une première borne reliée audit second point prédéterminé (B) et une seconde borne,
ledit amplificateur de courant différentiel comporte une première entrée (e$^+$) recevant un courant représentatif du courant traversant ladite capacité ($\frac{C}{2}$) du filtre à régler, une seconde entrée (e$^-$) recevant un courant représentatif du courant traversant ladite capacité supplémentaire ($\frac{C'}{2}$), une première sortie (s$^+$) inverseuse reliée audit premier point prédéterminé (A), et une seconde sortie suiveuse (s$^-$) reliée audit second point prédéterminé (B), lesdites première et seconde sortie dudit amplificateur de courant différentiel présentant un même gain d'amplification de courant différentiel.

En variante, suivant cet autre mode de réalisation, lesdits moyens d'amplification de courant comportent en outre un premier convoyeur de courant comportant une entrée (X) de courant à amplifier reliée à ladite seconde borne de ladite capacité (C/2) du filtre à régler, une sortie (Z) inverseuse de courant reliée à une première entrée (e$^+$) dudit amplificateur de courant différentiel, et une entrée (Y) de commande reliée audit second point prédéterminé (B), et un second convoyeur de courant comportant une entrée (X') de courant à amplifier reliée à ladite seconde borne de ladite capacité supplémentaire (C'/2), une sortie (Z') inverseuse de courant reliée à une seconde entrée (e-) dudit amplificateur de courant différentiel, et une entrée (Y') de commande reliée audit premier point déterminé (A), la première entrée (e+) dudit amplificateur de courant différentiel étant reliée à la sortie (Z) inverseuse dudit premier convoyeur de courant et la seconde entrée (e-) dudit amplificateur de courant différentiel étant reliée à la sortie (Z') inverseuse de courant dudit second convoyeur de courant.

Cette solution est plus facile à mettre en oeuvre que la précédente car les deux sorties de l'amplificateur de courant différentiel présentent ici un même gain. Si la capacité du filtre à régler et la capacité supplémentaire sont toutes les deux notées C/2, et si le gain de chacune des deux sorties de l'amplificateur de courant différentiel est noté G, la capacité fictive que constitue l'ensemble formé de la capacité du filtre à régler, de la capacité supplémentaire, des deux convoyeurs de courant et de l'amplificateur de courant différentiel est (G + 1/2) .C.

Le cas où la capacité du filtre à régler est du type flottante entraîne des modes de réalisation plus lourds à mettre en oeuvre que le cas où la capacité est référencée à la masse. Néanmoins, ces modes de réalisation sont très importants puisqu'ils permettent la réalisation d'un filtre entièrement différentiel, avec tous les avantages que cela implique (faible bruit et faible offset notamment).

Préférentiellement, ledit amplificateur de courant différentiel comprend :
- des moyens de génération d'un courant de mode commun de polarisation,
- un multiplieur translinéaire recevant, sur ses deux entrées, ledit courant de mode commun de polarisation et un courant de mode différentiel à amplifier, et délivrant, sur ses deux sorties, un courant de mode différentiel amplifié ;
- des moyens de polarisation dudit multiplieur translinéaire à partir dudit courant de polarisation reçu par ledit multiplieur translinéaire ; et
- des moyens de compensation du courant de mode commun sur lesdites sorties du multiplieur translinéaire ;

et lesdits moyens de multiplication de la capacité comprennent également des moyens permettant de faire varier le gain dudit multiplieur translinéaire.

Ainsi, l'amplification proprement dite est réalisée de façon originale grâce à un multiplieur translinéaire. Il est à noter en effet que les multiplieurs translinéaires sont généralement utilisés pour reproduire des fonctions mathématiques complexes ou encore pour réaliser des mélangeurs.

Par ailleurs, les moyens de polarisation du multiplieur translinéaire permettent d'obtenir une bonne précision sur le gain, et les moyens de compensation du courant de mode commun permettent d'obtenir une très bonne réjection de mode commun.

Dans un mode de réalisation préférentiel de l'invention, ledit multiplieur translinéaire comprend en parallèle au moins deux paires différentielles de transistors de sortie, et lesdits moyens permettant de faire varier le gain du multiplieur translinéaire sont des moyens d'activation / désactivation de chacune desdites paires différentielles de transistors de sortie dudit multiplieur translinéaire, ledit coefficient variable de multiplication de la capacité étant fonction du nombre de paires différentielles de transistors de sortie activées par lesdits moyens d'activation / désactivation.

Ainsi, en câblant en parallèle plusieurs paires différentielles qui peuvent ou non être activées, on réalise bien un gain variable, qui peut être programmable.

Selon une variante, lesdits moyens permettant de faire varier le gain du multiplieur translinéaire sont des moyens permettant de faire varier ledit courant de mode commun de polarisation reçu par ledit multiplieur translinéaire sur ses deux entrées.

Ainsi, le gain du multiplieur translinéaire varie en fonction du courant de polarisation, et la boucle d'asservissement du filtre à régler peut être entièrement analogique. De plus, si on utilise des transistors bipolaires et si le courant de mode commun est négligeable, le gain varie alors linéairement en fonction du courant de polarisation.

Avantageusement, ledit amplificateur de courant différentiel comprend des transistors appartenant au groupe comprenant les transistors bipolaires et les transistors MOS.

Suivant une autre caractéristique de l'invention, ledit filtre à régler étant du type recevant de façon continue un signal utile à filtrer, un dispositif d'ajustement de la fréquence de coupure d'un tel filtre comprend :
- des moyens de génération d'un signal de référence;
- un filtre d'étalonnage sensiblement identique audit filtre à régler et comprenant au moins une capacité sensiblement identique à ladite capacité dudit filtre à régler, ledit filtre d'étalonnage recevant ledit signal de référence et délivrant un signal de référence filtré,
- des moyens supplémentaires de multiplication sensiblement identiques auxdits moyens de multiplication de la capacité du filtre à régler et permettant de multiplier ladite capacité du filtre d'étalonnage par un coefficient variable ;
et lesdits moyens de commande des moyens de multiplication de la capacité du filtre à régler commandent également les moyens supplémentaires de multiplication de la capacité du filtre d'étalonnage, et comprennent des moyens d'analyse dudit signal de référence filtré, lesdits moyens d'analyse délivrant auxdits moyens de multiplication de la capacité du filtre à régler et auxdits moyens supplémentaires de multiplication de la capacité du filtre d'étalonnage un signal de correction dudit coefficient de multiplication de la capacité du filtre à régler et de la capacité du filtre d'étalonnage.

Le filtre à régler recevant en permanence un signal utile à filtrer, on ne peut pas interrompre son fonctionnement pour procéder à son étalonnage. On utilise donc un filtre supplémentaire, dit d'"étalonnage", qui est apparié au filtre à régler et permet donc d'effectuer l'étalonnage sans interrompre le fonctionnement du filtre à régler.

Ainsi, la capacité du filtre d'étalonnage est modifiée par une boucle rétroactive de correction à partir de la sortie du filtre d'étalonnage, cette boucle comprenant les moyens d'analyse du signal de référence filtré et les moyens supplémentaires de multiplication. Par contre, la capacité du filtre à régler n'est pas modifiée par une boucle rétroactive de correction à partir de la sortie du filtre à régler. En effet, les moyens de multiplication de la capacité du filtre à régler reçoivent le même signal de correction du coefficient de multiplication que les moyens supplémentaires de multiplication de la capacité du filtre d'étalonnage. Ce signal de correction correspond en quelque sorte au résultat de l'étalonnage effectué sur le filtre d'étalonnage, et permet d'ajuster simultanément la fréquence de coupure du filtre à régler et la fréquence de coupure du filtre d'étalonnage.

Suivant une autre caractéristique de l'invention, le filtre à régler étant du type recevant un signal utile à filtrer pendant des intervalles de temps de fonctionnement discontinus, un dispositif d'ajustement de la fréquence de coupure d'un tel filtre comprend :
- des moyens de génération d'un signal de référence ;
- des moyens de multiplexage recevant ledit signal utile à filtrer et ledit signal de référence et délivrant un signal multiplexé dans lequel ledit signal de référence est intercalé entre lesdits intervalles de temps de fonctionnement discontinus dudit signal utile à filtrer, ledit filtre à régler recevant ledit signal multiplexé et délivrant soit un signal utile filtré, lorsqu'il reçoit ledit signal utile à filtrer, soit un signal de référence filtré, lorsqu'il reçoit ledit signal de référence ;
et lesdits moyens de commande des moyens de multiplication de la capacité du filtre à régler comprennent des moyens d'analyse dudit signal de référence filtré, lesdits moyens d'analyse délivrant auxdits moyens de multiplication au moins un signal de correction dudit coefficient de multiplication de la capacité du filtre à régler.

Ici, contrairement au mode de réalisation présenté auparavant, le filtre à régler ne reçoit un signal utile à filtrer que de façon intermittente. Il est donc possible de procéder à l'étalonnage du filtre à régler pendant les phases de repos (c'est-à-dire de non réception du signal utile à filtrer). Le filtre d'étalonnage n'est par conséquent pas nécessaire dans ce second mode de réalisation. La précision de l'ajustement de la fréquence de coupure est meilleure que dans le premier mode de réalisation puisqu'il n'y a plus de contrainte d'appariement entre le filtre à régler et le filtre d'étalonnage.

La capacité du filtre à régler est modifiée par une boucle rétroactive de correction comprenant les moyens d'analyse du signal de référence filtré et les moyens de multiplication.

En ce qui concerne la boucle de compensation comprenant les moyens d'analyse du signal de référence filtré et les moyens de multiplication de la capacité du filtre à régler, l'invention propose trois modes de réalisation préférentiels.

Dans un premier mode de réalisation préférentiel de la boucle de compensation, ledit signal de référence est un signal temporel, et lesdits moyens d'analyse du signal de référence filtré comprennent :

- des moyens de comparaison, après un intervalle de temps prédéterminé suivant le début dudit signal temporel, d'une valeur caractéristique dudit signal de référence filtré avec une valeur seuil prédéterminée ; et
- des moyens de modification dudit signal de correction du coefficient de multiplication en fonction de ladite fréquence de coupure désirée et d'un résultat de comparaison fourni par lesdits moyens de comparaison.

Ainsi, dans le cas d'un filtre passe-bas, ladite valeur caractéristique du signal de référence filtré est inférieure à ladite valeur seuil prédéterminée lorsque la fréquence de coupure du filtre à régler est inférieure à une fréquence de coupure désirée, ladite valeur caractéristique du signal de référence filtré étant supérieure ou égale à ladite valeur seuil prédéterminée dans le cas contraire. Par contre, dans le cas d'un filtre passe-haut, les inégalités sont inversées.

Par exemple, le signal de réflexion est un échelon ou une impulsion, et la valeur caractéristique du signal de référence filtré est une tension. Ainsi, les moyens d'analyse détectent si, après un intervalle de temps prédéterminé, la tension en sortie du filtre a le temps d'arriver à une tension seuil prédéterminée. Si la réponse est négative, cela signifie que la fréquence de coupure du filtre à régler est inférieure à une fréquence de coupure désirée, et qu'il faut augmenter la fréquence de coupure du filtre à régler en modifiant le coefficient de multiplication de la capacité du filtre à régler.

Avantageusement, lesdits moyens d'analyse du signal de référence filtré modifient ledit signal de correction du coefficient de multiplication, par itérations successives, jusqu'à ce que ladite fréquence de coupure du filtre à régler devienne supérieure ou égale à ladite fréquence de coupure désirée. Ainsi, lors de chaque itération, on incrémente la fréquence de coupure du filtre à régler.

Dans un second mode de réalisation préférentiel de la boucle de compensation, ledit signal de référence possède une fréquence sensiblement égale à une fréquence de coupure désirée pour ledit filtre à régler, et en ce que lesdits moyens d'analyse du signal de référence filtré comprennent :

- des moyens de détection de l'amplitude maximale dudit signal de référence filtré ;
- des moyens de comparaison de ladite amplitude maximale du signal de référence filtré avec une amplitude seuil prédéterminée ; et
- des moyens de modification dudit signal de correction du coefficient de multiplication en fonction de ladite fréquence de coupure désirée et d'un résultat de comparaison fourni par lesdits moyens de comparaison.

Ainsi, dans le cas d'un filtre passe-bas, ladite amplitude maximale du signal de référence filtré est inférieure à ladite amplitude seuil prédéterminée lorsque la fréquence de coupure du filtre à régler est inférieure à ladite fréquence de coupure désirée, ladite amplitude maximale du signal de référence filtré étant supérieure ou égale à ladite amplitude seuil prédéterminée dans le cas contraire.

Avantageusement, lesdits moyens d'analyse du signal de référence filtré modifient ledit signal de correction du coefficient de multiplication, par asservissement de façon continue, jusqu'à ce que ladite fréquence de coupure du filtre à régler devienne supérieure ou égale à ladite fréquence de coupure désirée.

Ainsi, au lieu d'incrémenter la fréquence de coupure du filtre à régler lors d'itérations successives, on fait varier cette fréquence de coupure de façon continue. La compensation est ici analogique alors qu'elle était numérique dans le premier mode de réalisation.

Dans un troisième mode de réalisation préférentiel de la boucle de compensation, ledit filtre à régler étant un filtre du second ordre présentant un déphasage sensiblement égal à $\pi/2$ pour une fréquence sensiblement égale à sa fréquence de coupure,

ledit signal de référence possédant une fréquence sensiblement égale à une fréquence de coupure désirée pour ledit filtre à régler,

le dispositif d'ajustement comprend des moyens de déphasage recevant ledit signal de référence et délivrant un signal de comparaison déphasé d'environ $\pi/2$ par rapport audit signal de référence,

et lesdits moyens d'analyse du signal de référence filtré comprennent :

- des moyens de comparaison de phase entre ledit signal de référence filtré et ledit signal de comparaison ; et
- des moyens de modification dudit signal de correction du coefficient de multiplication en fonction de ladite fréquence de coupure désirée et d'un résultat de comparaison fourni par lesdits moyens de comparaison.

Ainsi, dans le cas d'un filtre passe-bas, la phase dudit signal de référence filtré est inférieure à la phase dudit signal de comparaison lorsque la fréquence de coupure du filtre à régler est inférieure à ladite fréquence de coupure désirée, la phase dudit signal de référence filtré étant supérieure ou égale à la phase dudit signal de comparaison dans le cas contraire.

Le filtre du second ordre peut être n'importe quel filtre connu (filtre de Butterworth, filtre de Tchebichev, etc...).

A la fréquence de coupure, le déphasage étant égal à $\pi/2$ pour n'importe quel filtre, on s'affranchit d'un paramètre (généralement noté z) qui a une influence importante sur l'amplitude au voisinage de la fréquence de coupure. Par conséquent, le signal de référence peut être fourni par un quartz, ce qui permet d'obtenir une excellente précision pour l'ajustement de la fréquence de coupure.

Avantageusement, lesdits moyens de comparaison de phase étant du type délivrant une valeur proportionnelle à l'écart de phase entre ledit signal de référence filtré et ledit signal de comparaison,

lesdits moyens d'analyse du signal de référence filtré modifient ledit signal de correction du coefficient de multiplication, par asservissement de façon continue, jusqu'à ce que ladite fréquence de coupure du filtre à régler devienne supérieure ou égale à ladite fréquence de coupure désirée.

Ainsi, la boucle de compensation est analogique avec modification continue de la fréquence de coupure du filtre à régler.

Selon une variante, lesdits moyens de comparaison de phase étant du type délivrant une information indiquant si la phase dudit signal de référence filtré est inférieure ou non à la phase dudit signal de comparaison,

lesdits moyens d'analyse du signal de référence filtré modifient ledit signal de correction du coefficient de multiplication, par itérations successives, jusqu'à ce que ladite fréquence de coupure du filtre à régler devienne supérieure ou égale à ladite fréquence de coupure désirée.

La boucle de compensation est ici numérique avec modification par approximations successives de la fréquence de coupure du filtre à régler.

L'invention concerne également un filtre du type comportant des dispositifs tels que présentés précédemment.

D'autres caractéristiques et avantages de l'invention apparaîtront à la lecture de la description suivante de plusieurs modes de réalisation préférentiels de l'invention, donnés à titre d'exemple indicatif et non limitatif, et des dessins annexés, dans lesquels :

- la figure 1 présente un schéma de principe d'un filtre à régler et d'un dispositif d'ajustement d'une fréquence de coupure d'un filtre à régler ;
- la figure 2A présente un schéma logique simplifié d'un mode de réalisation des moyens de multiplication de capacité apparaissant sur la figure 1, correspondant au cas où la capacité du filtre à régler est du type référencée à la masse ;
- la figure 2B présente un schéma équivalent au schéma de la figure 2A ;
- la figure 3 présente un schéma électrique simplifié d'un mode de réalisation préférentiel du convoyeur de courant apparaissant sur la figure 2A ;
- la figure 4A présente un schéma logique simplifié d'un mode de réalisation des moyens de multiplication de capacité apparaissant sur la figure 1, correspondant au cas où la capacité du filtre à régler est du type flottante entre deux points prédéterminés ;
- la figure 4B présente un schéma équivalent au schéma de la figure 4A ;
- la figure 5A présente un schéma logique simplifié d'un autre mode de réalisation des moyens de multiplication de capacité apparaissant sur la figure 1, correspondant au cas où la capacité du filtre à régler est du type flottante entre deux points prédéterminés;
- la figure 5B présente un schéma équivalent au schéma de la figure 5A ;
- la figure 6 présente un schéma électrique simplifié d'un mode de réalisation préférentiel de l'amplificateur de courant différentiel apparaissant sur la figure 5A ;
- la figure 7 reprend le schéma de la figure 6 et présente un schéma électrique simplifié d'un mode de réalisation préférentiel des moyens permettant de faire varier le gain du multiplieur translinéaire apparaissant sur la figure 6 ;
- la figure 8 présente un schéma électrique d'une variante du schéma de la figure 7 ;
- la figure 9 présente un schéma logique simplifié d'un premier mode de réalisation préférentiel d'un dispositif de réglage selon l'invention, correspondant au cas où le filtre à régler reçoit par intermittence un signal utile à filtrer ;
- la figure 10 présente un schéma logique simplifié d'un second mode de réalisation préférentiel d'un dispositif de réglage selon l'invention, correspondant au cas où le filtre à régler reçoit de façon continue un signal utile à filtrer ;
- la figure 11 présente un schéma logique simplifié d'un premier mode de réalisation d'une boucle de compensation apparaissant sur les figures 9 et 10 ;
- la figure 12 présente un schéma logique simplifié d'un second mode de réalisation d'une boucle de compensation apparaissant sur les figures 9 et 10 ;
- la figure 13 présente un schéma logique simplifié d'un troisième mode de réalisation d'une boucle de compensation apparaissant sur les figures 9 et 10.

L'invention concerne donc un dispositif de multiplication d'une capacité par un coefficient variable, notamment en vue de l'ajustement d'une fréquence de coupure d'un filtre à régler incluant une telle capacité. L'invention peut être mise en oeuvre avec n'importe quel filtre comprenant au moins une capacité et dont la fréquence de coupure à ajuster est fonction notamment de cette capacité.

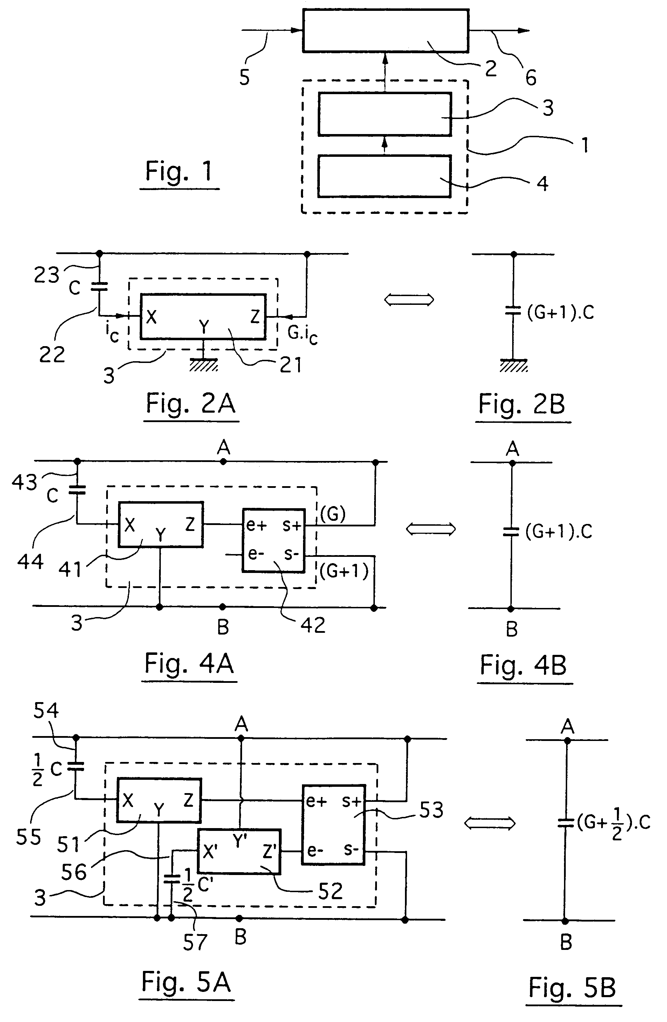

Comme présenté sur le schéma de principe de la figure 1, le dispositif d'ajustement 1 agit sur le filtre à régler 2. Le dispositif d'ajustement 1, qui reçoit par ailleurs un signal d'entrée à filtrer 5 et délivre un signal de sortie filtré 6, comprend des moyens de multiplication 3 de la capacité du filtre à régler 2 et des moyens de commande 4 des moyens de multiplication 3.

Sous le contrôle des moyens de commande, les moyens de multiplication 3 permettent de multiplier la capacité (notée C) du filtre à régler 2 par un coefficient variable de multiplication (noté k). La capacité C du filtre à régler est donc remplacée par une capacité fictive (notée k.C) fonction du coefficient de multiplication k.

En d'autres termes, la capacité C est remplacée par une structure se comportant comme une capacité fictive k.C, cette structure comprenant la capacité C du filtre à régler 2 et le dispositif d'ajustement 1. La valeur du coefficient de multiplication k est contrôlée par les moyens de commande de façon que la fréquence de coupure du filtre à régler 2 soit sensiblement égale à une fréquence de coupure désirée et prédéterminée.

Dans la suite de la description, les moyens de multiplication 3 comprennent des moyens d'amplification de courant, la multiplication par le coefficient k de la capacité C du filtre à régler 2, afin d'obtenir la capacité fictive k.C, est réalisée par l'amplification du courant traversant la capacité C du filtre à régler.

La capacité du filtre à régler 2 peut être soit référencée à la masse, soit flottante entre deux points prédéterminés.

La figure 2A présente un schéma logique simplifié d'un mode de réalisation des moyens de multiplication 3 apparaissant sur la figure 1. Ce mode de réalisation correspond au cas où la capacité C du filtre à régler 2 est du type référencée à la masse.

Dans ce premier mode de réalisation, les moyens de multiplication 3 de la capacité C du filtre à régler sont constitués d'un convoyeur de courant 21. Le convoyeur de courant comporte une entrée X de courant à amplifier ic reliée à une seconde borne 22 de la capacité C, une sortie inverseuse Z de courant amplifié $G.i_c$ reliée à une première borne 23 de la capacité C, et une entrée de commande Y reliée à la masse (cette entrée de commande Y reçoit en fait une tension de référence de l'entrée de courant à amplifier X, cette tension de référence étant la masse dans ce premier mode de réalisation). Le gain d'amplification de la sortie Z de courant amplifié étant noté G, la capacité fictive équivalente, telle que présentée sur la figure 2B, est (G+1).C. En d'autres termes, le coefficient de multiplication k de la capacité C du filtre à régler est G+1.

Un schéma électrique simplifié d'un mode de réalisation préférentiel du convoyeur de courant 21 est présenté sur la figure 3. Sur ce schéma électrique bien connu de l'homme du métier, on retrouve les entrées X et Y et la sortie Z. Avec n = 3 (n étant le nombre d'étages de transistors successifs), le gain de la sortie Z de courant amplifié peut varier entre 0 et 15, en fonction des valeurs des n couples de tensions de commande $(C_i, \overline{C_i})_{i \in [1,n]}$ des n étages de transistors.

La figure 4A présente un schéma logique simplifié d'un premier mode de réalisation préférentiel des moyens de multiplication 3 apparaissant sur la figure 1, ce mode de réalisation correspondant au cas où la capacité C du filtre à régler 2 est du type flottante entre deux points prédéterminés A et B.

Dans ce mode de réalisation, les moyens de multiplication 3 de la capacité C du filtre à régler sont constitués d'un convoyeur de courant 41 et d'un amplificateur de courant différentiel 42.

La capacité C du filtre à régler possède une première borne 43 reliée au premier point prédéterminé A et une seconde borne 44 reliée à l'entrée X de courant à amplifier du convoyeur de courant 41.

Le convoyeur de courant 41, qui peut être du type présenté auparavant en relation avec la figure 3, comporte l'entrée X de courant à amplifier reliée à la seconde borne 44 de la capacité C, une sortie inverseuse Z de courant amplifié reliée à une première entrée e+ de l'amplificateur de courant différentiel 42, et une entrée Y de commande reliée au second point prédéterminé B.

L'amplificateur de courant différentiel 42 comporte la première entrée e+ reliée à la sortie Z inverseuse de courant amplifié du convoyeur de courant 41, une seconde entrée e− non connectée, une première sortie suiveuse s+ présentant un premier gain d'amplification de courant différentiel G et reliée au premier point prédéterminé A, et une seconde sortie inverseuse s− présentant un second gain d'amplification de courant différentiel G + 1 et reliée au second point prédéterminé B.

Comme présenté sur la figure 4B, la capacité fictive équivalente est (G+1).C. Dans ce second mode de réalisation, la dissymétrie entre les gains G et G+1 respectivement des sorties s+ et s− de l'amplificateur de courant différentiel 42 vient de la nécessité de voir la même capacité sur les deux points prédéterminés A et B, et donc de retrouver les mêmes courants de part et d'autre de la capacité fictive (G+1).C.

La figure 5A présente un schéma logique simplifié d'un second mode de réalisation préférentiel des moyens de multiplication 3 apparaissant sur la figure 1, ce mode de réalisation correspondant également au cas où la capacité C du filtre à régler est du type flottante entre les deux points prédéterminés A et B.

Dans ce mode de réalisation, les moyens de multiplication 3 de la capacité (notée ici C/2) du filtre à régler sont constitués d'un premier 51 et d'un second 52 convoyeurs de courant, d'une capacité supplémentaire C'/2 sensiblement identique à ladite capacité C/2 du filtre à régler (C=C'), et d'un amplificateur de courant différentiel 53.

La capacité C du filtre à régler possède une première borne 54 reliée au premier point prédéterminé A, et une seconde borne 55 reliée à une entrée X de courant à amplifier du premier convoyeur de courant 51.

La capacité supplémentaire C' possède une première borne 57 reliée au second point prédéterminé B et une seconde borne 56 reliée à une entrée X' de courant à amplifier du second convoyeur de courant 52.

Le premier convoyeur de courant 51 comporte l'entrée X de courant à amplifier reliée à la seconde borne 55 de la capacité C'/2 du filtre à régler, une sortie inverseuse Z de courant amplifié reliée à une première entrée e⁺ de l'amplificateur de courant différentiel 53, et une entrée Y de commande reliée au second point prédéterminé B,

Le second convoyeur de courant comporte l'entrée X' de courant à amplifier reliée à la seconde borne 56 de la capacité supplémentaire C'/2, une sortie inverseuse Z' de courant amplifié reliée à une seconde entrée e⁻ de l'amplificateur de courant différentiel 53, et une entrée de commande Y' reliée au premier point déterminé A.

L'amplificateur de courant différentiel 53 comporte la première entrée e⁺ reliée à la sortie inverseuse Z de courant amplifié du premier convoyeur de courant 51, la seconde entrée e⁻ reliée à la sortie inverseuse Z' de courant amplifié du second convoyeur de courant 52, une première sortie inverseuse s⁺ reliée au premier point prédéterminé A, et une seconde sortie suiveuse S⁻ reliée au second point prédéterminé.

Dans cette variante, les première et seconde sorties s⁺ et s⁻ de l'amplificateur de courant différentiel 53 présente un même gain G d'amplification de courant différentiel. Comme présenté sur la figure 5B, la capacité fictive équivalente est (G + 1/2).C.

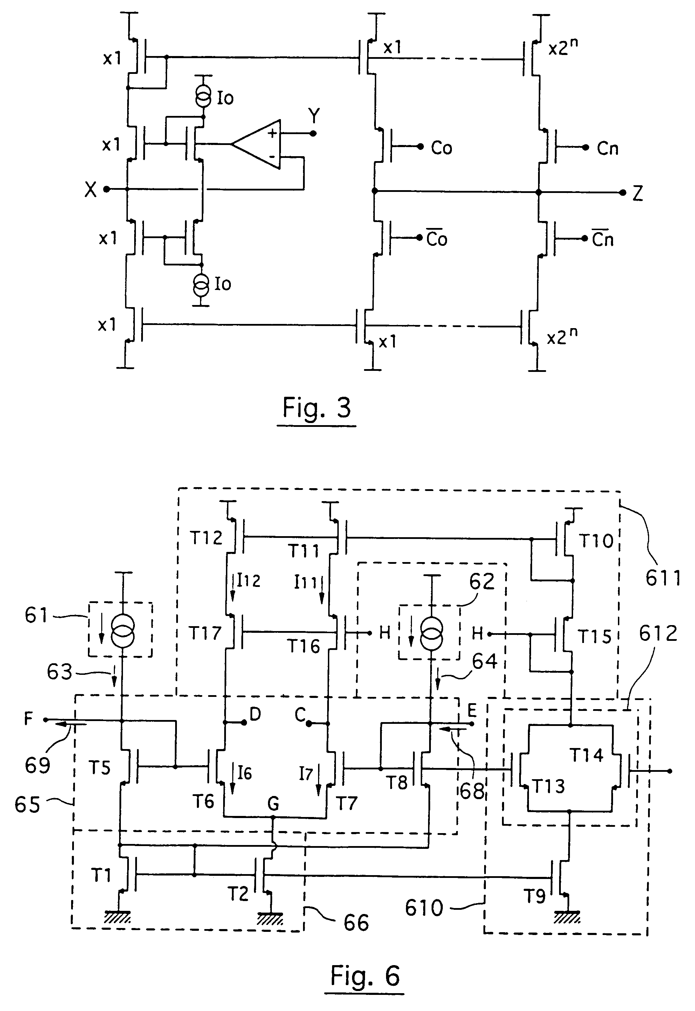

La figure 6 présente un schéma électrique simplifié d'un mode de réalisation préférentiel de l'amplificateur de courant différentiel 53.
Cet amplificateur de courant différentiel 53
- des moyens 61, 62 de génération d'un courant de mode commun de polarisation 63, 64 ;
- un multiplieur translinéaire 65 ;
- des moyens 66 de polarisation du multiplieur translinéaire 65 ; et
- des moyens 610, 611 de compensation du courant de mode commun en sortie du multiplieur 65.

Les moyens 61, 62 de génération d'un courant de mode commun de polarisation sont par exemple des sources de courant, ou encore des résistances.

Le multiplieur translinéaire 25 possède deux entrées différentielles E, F et deux sorties différentielles C, D. Sur ces deux entrées E, F, il reçoit le courant de mode commun de polarisation 63, 64 et un courant de mode différentiel à amplifier 68, 69. Sur ces deux sorties différentielles C, D, il délivre un courant de mode différentiel amplifié. Le multiplieur translinéaire 65 comprend une paire de transistors d'entrée T5, T8, et une paire différentielle de transistors de sortie T6, T7.

Dans cet exemple, les transistors utilisés dans le multiplieur translinéaire 65 sont du type NMOS et les sources des transistors de sortie de la paire différentielle T6, T7 sont reliées ensemble et constituent un point d'addition G des courants amplifiés I₆, I₇ traversant les transistors de sortie T6, T7.

Les moyens 66 de polarisation comprennent un miroir de courant (T1, T2), permettant une polarisation automatique du multiplieur translinéaire 65.

Les moyens 610, 611 de compensation du courant de mode commun n'ont aucune influence sur le gain différentiel du multiplieur translinéaire 65 mais assurent que les courants de mode commun (constitués du courant de polarisation et d'un éventuel courant supplémentaire) I₁₁, I₁₂ qu'ils délivrent aux transistors de sortie du multiplieur translinéaire sont identiques aux courants de polarisation traversant ces transistors de sortie. En d'autres termes, avec les références choisies, les moyens de compensation assurent que : I₁₁=I₇ et I₁₂=I₆. Ainsi, une éventuelle composante de mode commun (pouvant exister du fait que les moyens 26 de polarisation recopient dans ces transistors de sortie tout le courant de mode commun traversant les transistors d'entrée du multiplieur translinéaire) n'est pas reportée dans les sorties C, D de l'élément d'amplification. L'élément d'amplification présente donc une très bonne réjection de mode commun.

Dans ce mode de réalisation, les moyens de compensation du courant de mode commun comprennent :
- des moyens 610 de recopie du courant de mode commun de polarisation traversant le transistor T2, et
- des moyens 611 d'injection d'un courant recopié par les moyens 610 de recopie de courant, dans les bornes des transistors de sortie T6, T7 du multiplieur translinéaire 65 (bornes qui constituent les sorties différentielles C, D de l'élément d'amplification).

Les moyens 610 de recopie du courant de mode commun comprennent :
- un transistor T9 qui coopère avec le transistor T2 du miroir de courant (T1, T2) des moyens 66 de polarisation, afin de constituer un nouveau miroir de courant ; et
- des moyens 612 (par exemple deux transistors T13, T14) de maintien d'une tension constante sur le drain du transistor T9. Ainsi, les fluctuations de tension dues au courant différentiel se trouvent supprimées et la copie de courant est améliorée.

Le transistor T9 a pour fonction de reproduire le courant de mode commun de polarisation qui traverse les transistors T2 et T3.

Les moyens 611 d'injection du courant recopié sont par exemple constitués de deux premiers miroirs de courant (T10, T11), (T10, T12) possédant une première branche commune, et deux seconds miroirs de courant (T15, T16), (T15, T17) cascadés aux deux premiers miroirs de courant (T10, T11), (T10, T12) et permettent notamment d'améliorer la résistance de sortie des transistors T10, T11, T12 des premiers miroirs de courant.

Ainsi, le même courant de mode commun de polarisation traverse $I_{11}$, $I_{12}$, les deux transistors $T_{11}$, $T_{12}$, puis $T_{16}$, $T_{17}$, et arrive sur les deux sorties différentielles C, D de l'élément d'amplification. Ces courants $I_{11}$, $I_{12}$ sont égaux aux courants $I_6$, $I_7$ traversant les transistors de sortie $T_6$, $T_7$ du multiplieur translinéaire 65. Par conséquent, on garantit une très bonne réjection de mode commun.

Les transistors mis en oeuvre dans cet exemple d'amplificateur sont du type MOS. Il est clair toutefois qu'un tel amplificateur peut également être mis en oeuvre avec des transistors bipolaires, l'homme du métier ne rencontrant aucun obstacle majeur au passage du type MOS au type bipolaire.

Selon l'invention, les moyens de multiplication 3 de la capacité comprennent également des moyens permettant de faire varier le gain du multiplieur translinéaire 65.

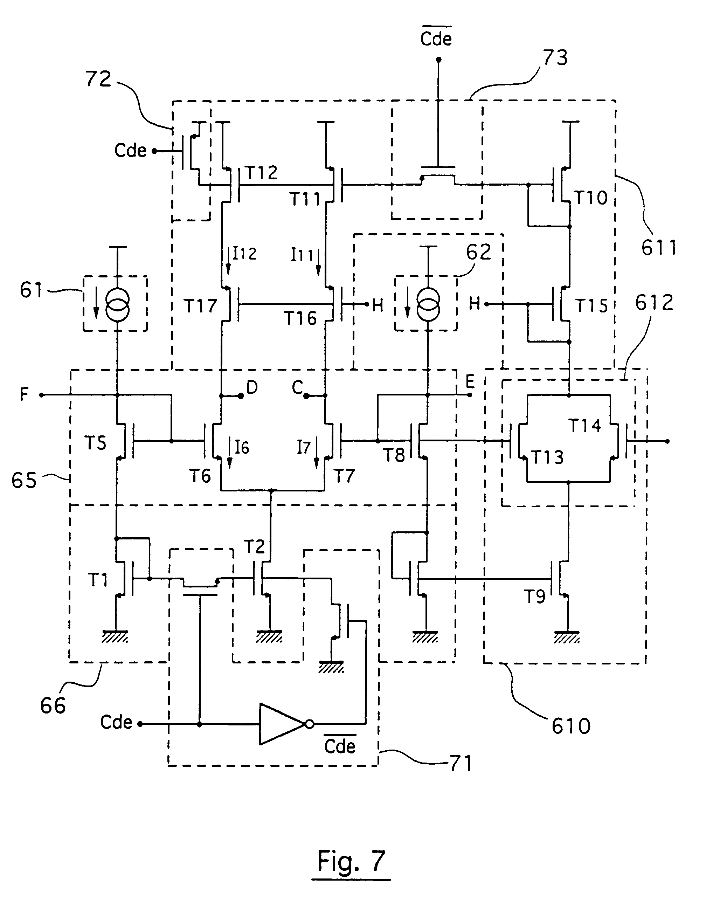

La figure 7 reprend le schéma de la figure 6 et présente un mode de réalisation préférentiel des moyens permettant de faire varier le gain du multiplieur translinéaire 65.

Dans ce mode de réalisation, afin de faire varier le gain, on câble en parallèle plusieurs paires différentielles de transistors de sortie (T6, T7) du multiplieur translinéaire 65, et chaque paire différentielle peut être ou non activée grâce à des moyens associés d'activation/désactivation 71, 72, 73. Ces moyens d'activation/désactivation se comportent comme de simples interrupteurs. Ainsi, lorsqu'ils reçoivent un signal de commande de niveau bas (cde = OV), les moyens d'activation/désactivation associés à une paire différentielle désactivent cette paire différentielle dont le gain est alors nul. Dans le cas contraire, ils l'activent.

Il y a autant de moyens d'activation/désactivation, et donc de signaux de commande que de paires différentielles câblées en parallèle. Il est à noter que dans un souci de simplification, seule une paire différentielle (T6, T7) (ainsi que les transistors T11, T12, T16, T17, T2 qui permettent sont fonctionnement) et les moyens de commande qui lui sont associés 71 à 73 ont été représentés. L'ensemble des valeurs des signaux de commande à un instant donné constituent un mot de commande en binaire.

Dans le cas particulier où les transistors des paires différentielles ont des tailles $2^n$ fois plus grandes que les transistors d'entrée (du multiplieur translinéaire également), et où les courants de polarisation sont également $2^n$ fois plus grands, la valeur du gain est donnée directement par le mot de commande en binaire.

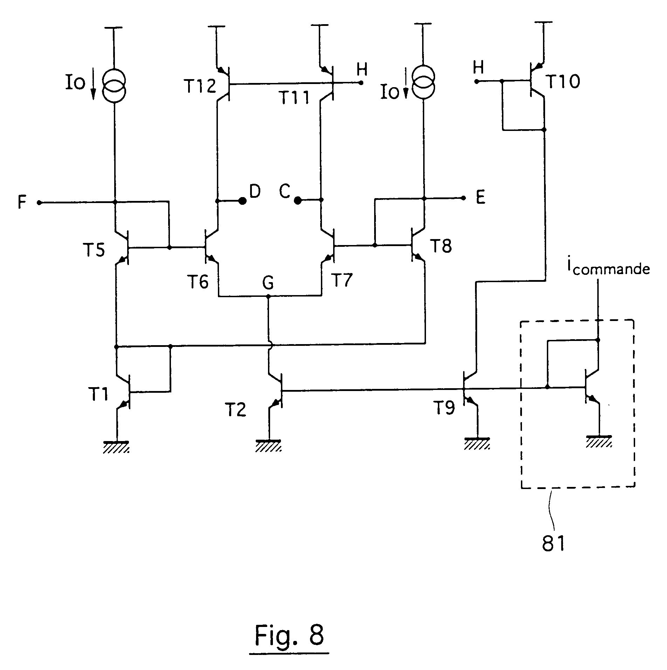

La figure 8 présente un schéma électrique d'une variante du schéma de la figure 7. Ceci correspond au cas où l'on utilise des transistors bipolaires et où le courant de mode commun est négligeable.

Le schéma électrique de l'amplificateur de courant différentiel est sensiblement identique à celui des figures 6 et 7. En effet, les seules différences sont les suivantes :
- les moyens de recopie du courant de mode commun de polarisation ne comprennent pas de moyens de maintien d'une tension constante sur le drain du transistor T9 de recopie du courant ;
- les moyens d'injection d'un courant recopié dans les bornes de transistors de sortie T6, T7 ne comprennent pas deux seconds miroirs de courant cascadés aux deux premiers miroirs de courant.

Il est clair toutefois que dans un autre mode de réalisation, l'amplificateur de courant différentiel utilisé dans cette variante pourrait être identique à celui utilisé dans le mode de réalisation présenté en relation avec la figure 6.

Dans cette variante, les moyens permettant de faire varier le gain du multiplieur translinéaire sont des moyens 81 permettant de faire varier le courant de polarisation $I_0$ reçu par le multiplieur translinéaire sur ses deux entrées E, F, en fonction d'un courant de commande $i_{commande}$. Ainsi, le gain G varie linéairement en fonction du courant de polarisation $I_0$ : G = $i_{commande}/I_0$.

La suite de la description présente deux principes distincts de calibration d'un filtre (c'est-à-dire d'ajustement d'une fréquence de coupure d'un filtre). Chacun de ces principes est lié à un mode de fonctionnement distinct du filtre à régler (c'est-à-dire à calibrer).

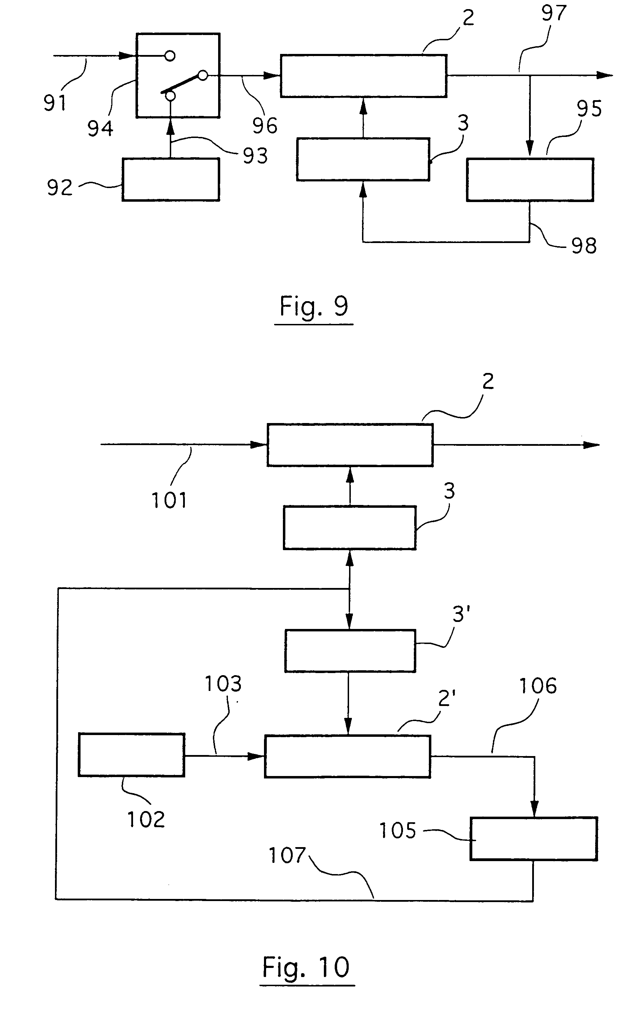

La figure 9 présente un schéma logique simplifié d'un premier mode de réalisation préférentiel d'un dispositif de réglage selon l'invention, correspondant au cas où le filtre à régler 2 reçoit par intermittence un signal utile à filtrer 91. Ce cas correspond notamment aux radiocommunications numériques du système GSM.

Le dispositif d'ajustement selon l'invention comprend alors :
- des moyens 92 de génération d'un signal de référence 93,
- des moyens 94 de multiplexage,
- des moyens 3 de multiplication de la capacité du filtre à régler, et
- des moyens 95 d'analyse.

Les moyens 94 de multiplexage reçoivent le signal utile à filtrer 91 et le signal de référence 93, et délivrent un signal multiplexé 96 constitué du signal utile à filtrer 91 pendant les intervalles de temps de fonctionnement discontinus et du signal de référence 93 pendant les phases de repos intercalées entre ces phases de fonctionnement.

Ainsi, le filtre à régler, 2 qui reçoit ce signal multiplexé 96, délivre un signal filtré 97 constitué d'un signal utile filtré quand le signal multiplexé 96 correspond au signal utile à filtrer 91, et d'un signal de référence filtré quand le signal multiplexé 96 correspond au signal de référence 93.

Les moyens 95 d'analyse reçoivent le signal filtré 97 mais ne traitent utilement que le signal de référence filtré, de façon à fournir aux moyens 3 de multiplication un signal de correction 98 du coefficient de multiplication de la capacité du filtre à régler.

La figure 10 présente un schéma logique simplifié d'un second mode de réalisation préférentiel d'un dispositif de réglage selon l'invention, correspond au cas où le filtre à régler 2 reçoit de façon continue un signal utile à filtrer 101.

Le dispositif d'ajustement selon l'invention comprend alors :
- des moyens de multiplication de la capacité du filtre à régler 2 ;
- des moyens 102 de génération d'un signal de référence 103 ;
- un filtre d'étalonnage 2' ;
- des moyens supplémentaires 3' de multiplication de la capacité du filtre d'étalonnage 2' ; et
- des moyens 105 d'analyse.

Le filtre d'étalonnage 2' est sensiblement identique au filtre à régler 2 et permet d'effectuer un étalonnage sans interrompre le fonctionnement du filtre à régler 2. Le filtre d'étalonnage 2' comprend au moins une capacité sensiblement identique à la capacité du filtre à régler et sa fréquence de coupure est donc sensiblement identique à celle du filtre à régler.

Les moyens 105 d'analyse reçoivent un signal de référence filtré 106 issu du filtre d'étalonnage 2' et fournissent un signal de correction 107 du coefficient de multiplication de capacité, d'une part aux moyens 3 de multiplication de la capacité du filtre à régler 2 et d'autre part aux moyens supplémentaires 3' de multiplication de la capacité du filtre d'étalonnage 2'.

Comme cela apparaît sur les figures 9 et 10, dans les deux modes de réalisation présentés, il existe une boucle de compensation. Dans le premier mode de réalisation (cf figure 9), la boucle de compensation peut être réalisée directement à partir de la sortie du filtre à régler 2. Par contre, dans le second mode de réalisation (cf figure 10), la boucle de compensation est réalisée à partir de la sortie du filtre d'étalonnage 2'.

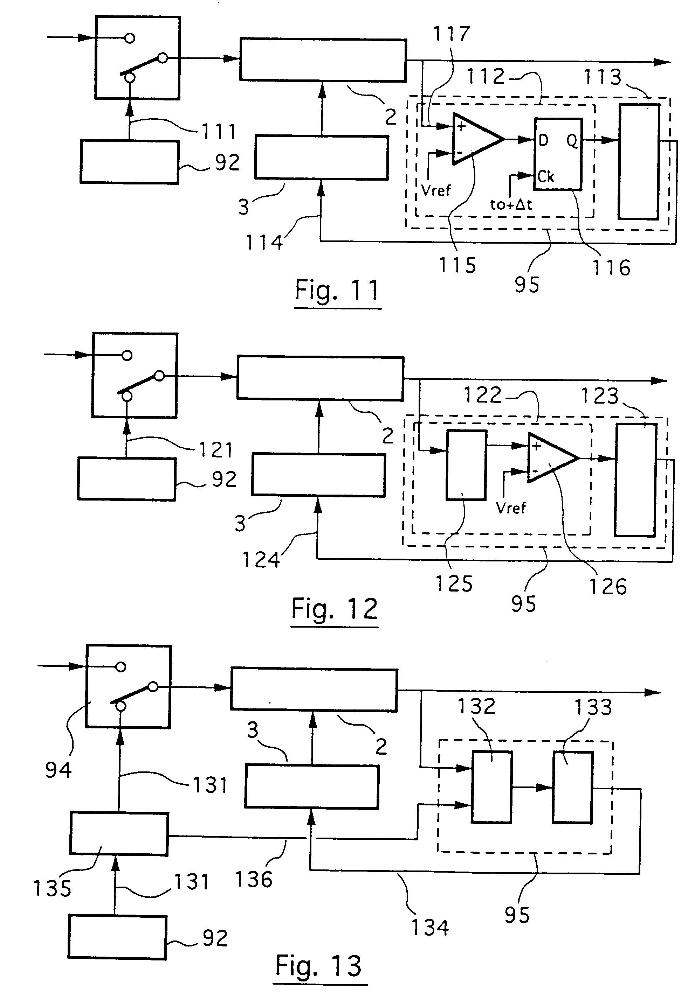

Les figures 11, 12 et 13 présentent chacune un mode de réalisation distinct de cette boucle de compensation. Même si ces trois modes de réalisation sont présentés dans le cas où le filtre à régler reçoit par intermittence le signal utile à filtrer, il est clair qu'ils peuvent également être mis en oeuvre dans le cas où le filtre à régler reçoit de façon continue le signal utile à filtrer. De même, les trois modes de réalisation correspondent à un filtre passe-bas, mais il est clair que l'invention peut également être mise en oeuvre avec un filtre passe-haut.

Dans le premier mode de réalisation de la boucle de compensation présenté sur la figure 11, le signal de référence est un signal temporel 111 (un échelon ou une impulsion par exemple) et les moyens 95 d'analyse comprennent des moyens 112 de comparaison et des moyens 113 de modification du signal de correction 114 du coefficient de multiplication des moyens 3 de multiplication.

Les moyens 112 de comparaison sont par exemple constitués d'un comparateur 115 et d'une bascule D116. Le comparateur 115 permet, lorsque le signal à filtrer est le signal de référence 111, de comparer le signal de référence filtré 117 avec une tension seuil Vref correspondant au niveau que doit atteindre le signal de référence filtré 117 après un intervalle de temps prédéterminé $\Delta t$ suivant le début $t_0$ du signal de référence 111. La bascule 116, dont l'entrée D est reliée à la sortie du comparateur 115, reçoit un signal d'horloge à l'instant $t_0 + \Delta t$, et sa sortie reste à zéro si la tension du signal de référence filtré 117 n'a pas eu le temps d'arriver à $V_{ref}$, c'est-à-dire si la fréquence de coupure du filtre à régler est inférieure à une fréquence de coupure prédéterminée. La fréquence de coupure prédéterminée est définie par la tension seuil Vref et le signal de référence.

Les moyens 113 de modification du signal de correction 114 du coefficient de multiplication reçoivent la sortie Q de la bascule 116 et, en fonction de la valeur de cette sortie Q, indiquent aux moyens 3 de multiplication de quelle façon modifier le coefficient de multiplication de la capacité du filtre à régler 2 (et donc la fréquence de coupure du filtre à régler 2).

En procédant par itérations successives, on peut modifier la fréquence de coupure du filtre à régler jusqu'à ce qu'elle soit égale à une fréquence de coupure prédéterminée. Ainsi, en partant par exemple d'une faible fréquence de coupure, on arrête les itérations lorsque la fréquence de coupure du filtre à régler devient supérieure ou égale à la fréquence de coupure désirée.

Le comparateur 115 fournissant une information binaire ("inférieur" ou "supérieur"), les moyens 113 peuvent être des moyens de traitement numérique et la précision de l'ajustement de la fréquence de coupure est limitée par l'incrément de fréquence minimum entre deux itérations.

Dans le second mode de réalisation de la boucle de compensation présenté sur la figure 12, le signal de référence 121 est par exemple une sinusoïde possédant une amplitude connue $V_0$ et une fréquence sensiblement égale à la fréquence de coupure désirée pour le filtre à régler 2, et les moyens 95 d'analyse comprennent des moyens 122 de comparaison et des moyens 123 de modification du signal de correction 124 du coefficient de multiplication des moyens 3 de multiplication.

Les moyens 122 de comparaison sont par exemple constitués d'un détecteur d'enveloppe 125 et un comparateur 126. Le détecteur d'enveloppe 125 permet de détecter l'amplitude maximale $V_1$ du signal de référence filtré. Le comparateur 126 compare cette amplitude maximale $V_1$ avec une amplitude seuil Vref correspondant au niveau que doit atteindre l'amplitude maximale $V_1$ du signal de référence. Si l'amplitude maximale $V_1$ est inférieure à l'amplitude seuil $V_{ref}$, c'est-à-dire si la fréquence de coupure du filtre à régler est inférieure à une fréquence de coupure prédéterminée (définie par l'amplitude de référence Vref et le signal de référence), les moyens 123 de modification (par exemple constitués d'un filtre passe-bas) indiquent aux moyens 3 de multiplication de modifier le coefficient de multiplication de la capacité du filtre à régler 2 de façon que la fréquence de coupure du filtre à régler soit augmentée.

Ainsi, la fréquence de coupure du filtre à régler est modifiée de façon continue (et non pas par incréments comme précédemment). La compensation est du type analogique et non plus numérique. La précision de l'ajustement de la fréquence de coupure du filtre à régler n'est limitée que par la précision des différents éléments analogiques (essentiellement la précision sur les amplitudes $V_0$ et $V_{ref}$).

Dans le troisième mode de réalisation de la boucle de compensation présenté sur la figure 13, le filtre à régler est un filtre du second ordre dont la fonction de transfert est de la forme : $1/(1 + 2z.w/w_c + j^2.w^2/w^2c)$. Le déphasage à $w_c$ (c'est-à-dire à la fréquence de coupure) est égal à $\pi/2$.

Le signal de référence 131 possède une fréquence sensiblement égale à une fréquence de coupure désirée pour le filtre à régler 2.

Le dispositif de l'invention comprend des moyens 135 de déphasage (par exemple un diviseur de Johnson) recevant le signal de référence 131 et délivrant d'une part ce même signal de référence 131 au filtre à régler (par l'intermédiaire des moyens 94 de multiplexage) et d'autre part un signal de comparaison 136 déphasé d'environ $\pi/2$ par rapport au signal de référence 131.

Les moyens 95 d'analyse comprennent des moyens 132 de comparaison de phase et des moyens 133 de modification du signal de correction 134 du coefficient de multiplication de moyens 3 de multiplication.

Les moyens 132 de comparaison de phase permettent de comparer le signal de référence filtré et le signal de comparaison 136 qui possède le déphasage (à savoir $\pi/2$ par rapport au signal de référence 131) que doit posséder le signal de référence filtré si la fréquence de coupure du filtre à régler est égale à la fréquence du signal de référence 131 (c'est-à-dire si la fréquence de coupure du filtre à régler est égale à la fréquence de coupure désirée).

Si les moyens 132 de comparaison de phase délivrent un signal (tension ou courant) proportionnel à l'écart de phase entre le signal de référence filtré et le signal de comparaison, les moyens 133 d'analyse sont par exemple constitués d'un filtre passe-bas (et éventuellement un amplificateur) et permettent un ajustement continu de la fréquence de coupure du filtre à régler 2.

Si les moyens 132 de comparaison de phase délivrent une information binaire ('inférieur" ou "supérieur"), les moyens 133 d'analyse sont par exemple des moyens de traitement numérique et permettent un ajustement par approximations successives de la fréquence de coupure du filtre à régler 2.

## Revendications

1. Dispositif de multiplication d'une capacité par un coefficient variable, notamment en vue du réglage de la fréquence de coupure d'un filtre incluant une telle capacité, dispositif comportant des moyens d'amplification de courant permettant d'amplifier un courant traversant ladite capacité, caractérisé en ce que, ladite capacité étant du type flottante entre un premier (A) et un second (B) point déterminé, lesdits moyens d'amplification de courant comportent un amplificateur de courant différentiel (42, 53).

2. Dispositif selon la revendication 1, caractérisé en ce que ledit amplificateur de courant différentiel (42) comporte une première entrée (e+) recevant un courant représentatif du courant traversant ladite capacité, une seconde entrée (e-) non connectée, une première sortie (s+) inverseuse présentant un premier gain d'amplification de courant différentiel G et reliée audit premier point prédéterminé (A), et une seconde sortie (s-) suiveuse présentant un second gain d'amplification de courant différentiel G+1 et reliée audit second point prédéterminé (B).

3. Dispositif selon la revendication 1, ladite capacité (C/2) du filtre à régler étant du type flottante entre un premier (A) et un second (B) point prédéterminé, caractérisé en ce que lesdits moyens (3) d'amplification de courant comportent en outre une capacité supplémentaire (C'/2) sensiblement identique à ladite capacité du filtre à régler, la capacité (C/2) du filtre à régler possédant une première borne (54) reliée audit premier point prédéterminé (A), et une seconde borne (55), la capacité supplémentaire (C'/2) possédant une première borne (57) reliée audit second point prédéterminé (B) et une seconde borne (56), ledit amplificateur de courant différentiel (53) comporte une première entrée ($e^+$) recevant un courant représentatif du courant traversant ladite

capacité $(\frac{C}{2})$ du filtre à régler, une seconde entrée (e⁻) recevant un courant représentatif du courant traversant ladite capacité supplémentaire $(\frac{C'}{2})$, une première sortie (s⁺) inverseuse reliée audit premier point prédéterminé (A), et une seconde sortie suiveuse (s⁻) reliée audit second point prédéterminé (B), lesdites première et seconde sortie dudit amplificateur de courant différentiel présentant un même gain d'amplification de courant différentiel.

4. Dispositif selon la revendication 2, caractérisé en ce que lesdits moyens (3) d'amplification de courant comportent en outre un convoyeur de courant (41), ladite capacité (C) possédant une première borne (43) reliée audit premier point prédéterminé (A), et une seconde borne (44) reliée à une entrée (X) de courant à amplifier dudit convoyeur de courant (41), ledit convoyeur de courant (41) comportant ladite entrée (X) de courant à amplifier reliée à la seconde borne (44) de ladite capacité, une sortie (Z) inverseuse de courant reliée à une première entrée (e⁺) dudit amplificateur de courant différentiel (42), et une entrée (Y) de commande reliée audit second point prédéterminé (B), et la première entrée (e⁺) dudit amplificateur de courant différentiel étant reliée à la sortie (Z) inverseuse de courant dudit convoyeur de courant.

5. Dispositif selon la revendication 3, caractérisé en ce que lesdits moyens d'amplification de courant comportent en outre un premier convoyeur de courant (51) comportant une entrée (X) de courant à amplifier reliée à ladite seconde borne (55) de ladite capacité (C/2) du filtre à régler, une sortie (Z) inverseuse de courant reliée à une première entrée (e⁺) dudit amplificateur de courant différentiel (53), et une entrée (Y) de commande reliée audit second point prédéterminé (B), et un second convoyeur de courant (52) comportant une entrée (X') de courant à amplifier reliée à ladite seconde borne (56) de ladite capacité supplémentaire (C'/2), une sortie (Z') inverseuse de courant reliée à une seconde entrée (e-) dudit amplificateur de courant différentiel (53), et une entrée (Y') de commande reliée audit premier point déterminé (A), la première entrée (e+) dudit amplificateur de courant différentiel (53) étant reliée à la sortie (Z) inverseuse dudit premier convoyeur de courant (51) et la seconde entrée (e-) dudit amplificateur de courant différentiel (53) étant reliée à la sortie (Z') inverseuse de courant dudit second convoyeur de courant.

6. Dispositif selon l'une des revendications 4 et 5, caractérisé en ce qu'un convoyeur de courant est en outre tel qu'il fournit sur sa sortie (Z, Z') inverseuse de courant, un courant amplifié.

7. Dispositif selon l'une des revendications 3, 5, 6, caractérisé en ce que ledit amplificateur de courant différentiel (53) comprend :
   - des moyens (61, 62) de génération d'un courant de mode commun de polarisation,
   - un multiplieur translinéaire (65) recevant, sur ses deux entrées (E, F), ledit courant de mode commun de polarisation et un courant de mode différentiel à amplifier, et délivrant, sur ses deux sorties (C, D), un courant de mode différentiel amplifié ;
   - des moyens (66) de polarisation dudit multiplieur translinéaire (65) à partir dudit courant de polarisation reçu par ledit multiplieur translinéaire ; et
   - des moyens (610, 611) de compensation du courant de mode commun sur lesdites sorties du multiplieur translinéaire ;
   et en ce que ledit dispositif comprend également des moyens (71, 72, 73 ; 81) permettant de faire varier le gain dudit multiplieur translinéaire.

8. Dispositif selon la revendication 7, caractérisé en ce que ledit multiplieur translinéaire (65) comprend en parallèle au moins deux paires différentielles de transistors de sortie (T6, T7), et en ce que lesdits moyens (71, 72, 73) permettant de faire varier le gain du multiplieur translinéaire sont des moyens d'activation / désactivation de chacune desdites paires différentielles de transistors de sortie dudit multiplieur translinéaire, ledit coefficient variable de multiplication de la capacité étant fonction du nombre de paires différentielles de transistors de sortie activées par lesdits moyens d'activation / désactivation.

9. Dispositif selon la revendication 7, caractérisé en ce que lesdits moyens permettant de faire varier le gain du multiplieur translinéaire sont des moyens (81) permettant de faire varier ledit courant de mode commun de polarisation reçu par ledit multiplieur translinéaire sur ses deux entrées.

10. Dispositif selon l'une quelconque des revendications 2 à 9, caractérisé en ce que ledit amplificateur de courant différentiel comprend des transistors appartenant au groupe comprenant les transistors bipolaires et les transistors MOS.

11. Dispositif de réglage de la fréquence de coupure d'un filtre du type comprenant au moins une capacité et des moyens (3) de multiplication de cette capacité par un coefficient variable, sous la commande de moyens de commande (4), caractérisé en ce que ledit filtre à régler (2) étant du type recevant de façon continue un signal utile à filtrer (91), il comprend :

- des moyens (102) de génération d'un signal de référence (103) ;
- un filtre d'étalonnage (2') sensiblement identique audit filtre à régler (2) et comprenant au moins une capacité sensiblement identique à ladite capacité dudit filtre à régler, ledit filtre d'étalonnage (2') recevant ledit signal de référence (103) et délivrant un signal de référence filtré (106),
- des moyens supplémentaires (3') de multiplication sensiblement identiques auxdits moyens (3) de multiplication de la capacité du filtre à régler et permettant de multiplier ladite capacité du filtre d'étalonnage par un coefficient variable ;

et en ce que lesdits moyens (4) de commande des moyens (3) de multiplication de la capacité du filtre à régler commandent également les moyens supplémentaires (3') de multiplication de la capacité du filtre d'étalonnage, et comprennent des moyens (105) d'analyse dudit signal de référence filtré (106), lesdits moyens (105) d'analyse délivrant auxdits moyens (3) de multiplication de la capacité du filtre à régler et auxdits moyens supplémentaires (3') de multiplication de la capacité du filtre d'étalonnage un signal (107) de correction dudit coefficient de multiplication de la capacité du filtre à régler et de la capacité du filtre d'étalonnage.

12. Dispositif de réglage de la fréquence de coupure d'un filtre du type comprenant au moins une capacité et des moyens (3) de multiplication de cette capacité par un coefficient variable, sous la commande de moyens de multiplication (4), caractérisé en ce que ledit filtre à régler (2) étant du type recevant un signal utile à filtrer (91) pendant des intervalles de temps de fonctionnement discontinus, il comprend :

- des moyens (92) de génération d'un signal de référence (103) ;
- des moyens (94) de multiplexage recevant ledit signal utile à filtrer et ledit signal de référence et délivrant un signal multiplexé (96) dans lequel ledit signal de référence est intercalé entre lesdits intervalles de temps de fonctionnement discontinus dudit signal utile à filtrer, ledit filtre à régler recevant ledit signal multiplexé et délivrant soit un signal utile filtré, lorsqu'il reçoit ledit signal utile à filtrer, soit un signal de référence filtré, lorsqu'il reçoit ledit signal de référence ;

et en ce que lesdits moyens (4) de commande des moyens (3) de multiplication de la capacité du filtre à régler comprennent des moyens (95) d'analyse dudit signal de référence filtré, lesdits moyens d'analyse délivrant auxdits moyens de multiplication au moins un signal (98) de correction dudit coefficient de multiplication de la capacité du filtre à régler.

13. Dispositif selon l'une quelconque des revendications 11 et 12, caractérisé en ce que ledit signal de référence est un signal temporel (111), et en ce que lesdits moyens (95) d'analyse du signal de référence filtré comprennent :

- des moyens (112) de comparaison, après un intervalle de temps prédéterminé suivant le début dudit signal temporel, d'une valeur caractéristique dudit signal de référence filtré avec une valeur seuil prédéterminée ($V_{ref}$) ; et
- des moyens (113) de modification dudit signal (114) de correction du coefficient de multiplication en fonction de ladite fréquence de coupure désirée et d'un résultat de comparaison fourni par lesdits moyens de comparaison.

14. Dispositif selon la revendication 13, caractérisé en ce que lesdits moyens (95) d'analyse du signal de référence filtré modifient ledit signal (114) de correction du coefficient de multiplication, par itérations successives, jusqu'à ce que ladite fréquence de coupure du filtre à régler devienne sensiblement égale à ladite fréquence de coupure désirée.

15. Dispositif selon l'une quelconque des revendications 11 et 12, caractérisé en ce que ledit signal de référence (121) possède une fréquence sensiblement égale à une fréquence de coupure désirée pour ledit filtre à régler (2), et en ce que lesdits moyens (95) d'analyse du signal de référence filtré comprennent :

- des moyens (122) de détection de l'amplitude maximale dudit signal de référence filtré ;
- des moyens (126) de comparaison de ladite amplitude maximale du signal de référence filtré avec une amplitude seuil prédéterminée ($V_{ref}$) ; et
- des moyens (123) de modification dudit signal de correction du coefficient de multiplication en fonction de ladite fréquence de coupure désirée et d'un résultat de comparaison fourni par lesdits moyens de comparaison.

16. Dispositif selon la revendication 15, caractérisé en ce que lesdits moyens (95) d'analyse du signal de référence filtré modifient ledit signal (124) de correction du coefficient de multiplication, par asservissement de façon continue, jusqu'à ce que ladite fréquence de coupure du filtre à régler devienne sensiblement égale à ladite fréquence de coupure désirée.

17. Dispositif selon l'une quelconque des revendications 11 et 12, ledit filtre à régler (2) étant un filtre du second ordre présentant un déphasage sensiblement égal à π/2 pour une fréquence sensiblement égale à sa fréquence de coupure,

caractérisé en ce que ledit signal de référence (131) possède une fréquence sensiblement égale à une fréquence de coupure désirée pour ledit filtre à régler,

en ce qu'il comprend des moyens (135) de déphasage recevant ledit signal de référence (131) et délivrant un signal de comparaison (136) déphasé d'environ π/2 par rapport audit signal de référence,

et en ce que lesdits moyens (95) d'analyse du signal de référence filtré comprennent :
   - des moyens (132) de comparaison de phase entre ledit signal de référence filtré et ledit signal de comparaison ; et
   - des moyens (133) de modification dudit signal (134) de correction du coefficient de multiplication en fonction de ladite fréquence de coupure désirée et d'un résultat de comparaison fourni par lesdits moyens de comparaison.

18. Dispositif selon la revendication 17, lesdits moyens (132) de comparaison de phase étant du type délivrant une valeur proportionnelle à l'écart de phase entre ledit signal de référence filtré et ledit signal de comparaison,

caractérisé en ce que lesdits moyens (95) d'analyse du signal de référence filtré modifient ledit signal (134) de correction du coefficient de multiplication, par asservissement de façon continue, jusqu'à ce que ladite fréquence de coupure du filtre à régler devienne sensiblement égale à ladite fréquence de coupure désirée.

19. Dispositif selon la revendication 17, lesdits moyens (132) de comparaison de phase étant du type délivrant une information indiquant si la phase dudit signal de référence filtré est inférieure ou non à la phase dudit signal de comparaison,

caractérisé en ce que lesdits moyens (95) d'analyse du signal de référence filtré modifient ledit signal (134) de correction du coefficient de multiplication, par itérations successives, jusqu'à ce que ladite fréquence de coupure du filtre à régler devienne sensiblement égale à ladite fréquence de coupure désirée.

20. Filtre du type comportant un dispositif suivant l'une quelconque des revendications 1 à 19.

EP 0 667 677 A1

Fig. 1

Fig. 2A

$(G+1).C$

Fig. 2B

Fig. 4A

$(G+1).C$

Fig. 4B

Fig. 5A

$(G+\frac{1}{2}).C$

Fig. 5B

15

Fig. 3

Fig. 6

Fig. 7

Fig. 8

Fig. 9

Fig. 10

EP 0 667 677 A1

Fig. 11

Fig. 12

Fig. 13

20

**Office européen des brevets**

# RAPPORT DE RECHERCHE EUROPEENNE

Numero de la demande

EP 95 40 0246

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X<br>A | WO-A-81 02819 (MOTOROLA) 1 Octobre 1981<br>* page 7, ligne 25 - page 13, ligne 9 *<br>--- | 1<br>2,3 | H03H11/04<br>H03H11/40<br>H03H11/48 |
| A | WO-A-93 03543 (BELL COMMUNICATIONS RESEARCH) 18 Février 1993<br>* page 3, ligne 7 - page 3, ligne 34; figure 1 *<br>--- | 1 | |
| A | INTERNATIONAL JOURNAL OF ELECTRONICS,<br>vol. 64, LONDON GB,<br>page 941<br>SITTHICHAI POOKAIYAUDOM ET AL 'EICIENT CIRCUIT IMPLEMENTATIONS OF CURRENT CONVEYORS, NEGATIVE IMPEDANCE CONVERTERS AND NONLINEAR IMPEDANCE CONVERTERS USING OPERATIONAL TRANSCONDUCTANCE AMPLIFIERS'<br>* le document en entier *<br>----- | 3,7 | |

**DOMAINES TECHNIQUES RECHERCHES (Int.Cl.6)**

H03H

Le présent rapport a été établi pour toutes les revendications

| Lieu de la recherche | Date d'achèvement de la recherche | Examinateur |
|---|---|---|
| LA HAYE | 28 Avril 1995 | Coppieters, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)